# EUROPEAN PATENT SPECIFICATION

(11) **EP 0 472 804 B1**
(45) Date of publication and mention of the grant of the patent: **30.07.1997**
(21) Application number: 91103153.2
(22) Date of filing: 02.03.1991
(51) Int. Cl.: H01L 21/3205, H01L 21/285

(54) **Copper germanium compounds capable of being produced at low temperature**
Kupfer-Germanium Verbindungen, die bei Niedrigtemperatur hergestellt werden können
Composés cuivre-germanium pouvant être produits à basse température

(30) Priority: 01.08.1990 US 561045
(43) Date of publication of application: 04.03.1992
(60) Divisional application: 96120744.6
(73) Proprietor: International Business Machines Corporation, Armonk, N.Y. 10504 (US)
(72) Inventor: Aboelfotoh, Mohamed Osama, Poughkeepsie, N.Y. 12603 (US); Krusin-Elbaum, Lia, Dobbs Ferry, New York 10522 (US); Sun, Yuan-Chen, Katonah, New York 10536 (US)
(74) Representative: Rach, Werner, Dr.

(56) References cited:
- EP-A- 0 419 763
- DE-A- 1 806 980
- JEE JOURNAL OF ELECTRONIC ENGINEERING, Vol 27, No 280, April 1990, page 49, Tokyo, JP
- IBM TECHNICAL DISCLOSURE BULLETIN, Vol 32, N0 11, April 1990, pages 54-55, New York, US
- PATENT ABSTRACTS OF JAPAN, Vol 6, No 170,(E.128)(1048), 3 September 1982, & JP-A-57087127 (SUWA SEIKOSHA K.K) 31.05.1982
- JOURNAL OF APPLIED PHYSICS, Vol 67, No 1, 1 January 1990, pages 566-569, New York, US
- PATENT ABSTRACTS OF JAPAN, Vol 14, No 346 (E-956) 26 July 1990 & JP-A-02119140 (Seiko Epson Corp) 07.05.1990

## Description

The invention relates to the production and use of Cu₃Ge layer and more particularly to the use of copper in VLSI technology as interconnection metallization in silicon (Si) and germanium (Ge), electronic devices.

The metal copper (Cu) has very good electrical conductivity and as a result there is currently a wide interest in and effort toward developing Cu as interconnection metallization in future silicon (Si), and germanium (Ge) electronic devices. However, it is known that Cu diffuses into Si, producing deep energy levels in the Si energy gap which can act as efficient recombination centers thus affecting minority-carrier lifetime. This, in turn, results in severe degradation of the electrical characteristics of such devices as metal-Si Schottky-barrier and p-n junctions. Also, it is known that Cu in Ge introduces several acceptor energy levels in the energy band gap of Ge. Such energy levels similarly can act as recombination centers or as traps giving rise to excess current which causes severe degradation of the electrical characteristics of such devices as np and metal-Ge Schottky-barrier junctions.

EP-A- 0 419 763 (State of the art document, under Art. 54(3) EPC) discloses a stable interconnection metallization for VLSI devices including copper silicide and copper germanide (Cuₓ Ge₁₋ₓ).

IBM Technical Disclosure Bulletin, Vol. 32, No. 11, April 1990, p.55 f. describes a low temperature process for making silicon FET devices which utilize copper silicide (Cu₃Si) as contact and interconnections metallization.

Following from the experience and belief in the art that Cu always diffuses in silicon and other single crystalline semiconductor materials, a problem has existed in the art to create Cu-semiconductor interfaces in VLSI devices while avoiding degradation of current-voltage characteristics in such devices.

The process and system of the present invention offer a solution to this problem as well as offering other advantageous applications.

In accordance with the present invention, it has been found that in the preferred VLSI embodiment junctions formed by the deposition of Cu on a layer of Ge on a single crystalline semiconductor substrate, e.g. Si held at room temperature, are treated, such as by maintaining them at room temperature for extended periods or accelerating the process by annealing, e.g., at 200°C for 30 min. In the as-deposited state, these junctions display highly nonideal current-voltage characteristics, that is, they exhibit large excess current under forward and reverse bias conditions; but, it has been found that, remarkably, simple treatment, e.g., by low-temperature annealing, results in junctions which exhibit ideal current-voltage characteristics. Characterization of these junctions using techniques such as deep-level transient spectroscopy reveals that such low-temperature annealing causes the disappearance of the deep energy levels which are believed to be acting as efficient recombination centers giving rise to large excess current under forward and reverse bias conditions. Moreover, the ideal current-voltage characteristics displayed by the comparatively low-temperature, 200°C - annealed junctions are found to remain unaffected by further annealing of the junctions at higher temperatures such as 600°C for 30 min. These findings are very significant in that they show that copper, through the vehicle of the resulting Cu-Ge interface, can be used as an "electrically" stable interconnection metallization in future VLSI devices, e.g., as a high temperature (600-800°C) stability Ohmic/Schottky contact to Si or as a Cu diffusion barrier.

Additional embodiments can include a Cu layer on a Ge layer on Si substrate. The various embodiments can be applied in advantageous ways in the production of FET, CMOS, NMOS and like devices as described in detail below.

Consequently, it has been found that a Cu can be readily combined with semiconductor materials and that a Cu interconnection metallization for integrated circuits can be formed by depositing a Cu film on a layer of Ge held at room temperature, and treating the Cu coated substrate to form a Cu₃Ge layer interface junction which has ideal current-voltage characteristics.

The present invention therefore involves a system and method for forming an interconnection metallization for integrated circuits wherein a Cu film is deposited on a layer of Ge on a single crystalline semiconductor substrate, held at room temperature, and the Cu-coated substrate is treated to form a Cu₃Ge layer interface junction. The treatment may consist of merely maintaining the Cu-coated Ge layer at room temperature for an extended period, e.g., at least about two hours, but typically several hours and possibly for weeks, depending on the thickness of the Cu film. However, in keeping with present processes for manufacturing VLSI devices, the formation of the interface junction may be accelerated by heating the Cu-coated Ge layer to a temperature of at least about 150°C for at least about 20 minutes, and preferably to 200°C for 30 min., to form a Cu₃Ge layer interface junction.

For a better understanding of the present invention, together with further objects and advantages, preferred embodiments of the invention are described in the following with reference to the accompanying drawings, in which:
- Figure 1: is a diagrammatic cross-sectional view showing a FET device in accordance with an embodiment out of the scope of the invention using copper silicide (Cu₃Si) to contact source and drain regions and wherein a layer of Cu is first deposited over the entire Si substrate;
- Figure 2: is a view as in Fig. 1 of the device after heating to form a copper silicide (Cu₃Si) layer and the excess Cu Si having being chemically removed;
- Figure 3: is a diagrammatic cross-sectional view illustrating a two level interconnecting structure, of a form considered likely to be used for multilevel interconnect metallization, containing a void-open failure in the upper line just above the connecting stud;
- Figure 4: is a view as in Fig. 3 showing components in keeping with the Cu₃Ge produced by the method of the invention for obviating void-open failures;
- Figs. 5 through 8: diagrammatically illustrate the sequence of a self-aligned Cu₃Ge process, in accordance with the invention, to produce low resistance self-aligned Cu₃Ge for advanced bipolar, CMOS, and BiCMOS devices;
- Figs. 9 through 11: illustrate respectively possible CMOS and bipolar devices with self-aligned Cu₃Ge over emitter, base, collector source, drain and gate;
- Figs. 12 through 16: diagrammatically illustrate an improved technique for fabricating a Cu₃Ge, having a work function of 4.6 eV, as a midgap gate metal to be used directly over SiO₂ at very low temperatures for applications in CMOS devices in accordance with the invention;
- Figs. 17 through 19: diagrammatically illustrate an alternative technique to that shown in Figs. 17 through 21;
- Figure 20: shows the temperature dependence of the /C resistivity of Cu₃Ge.

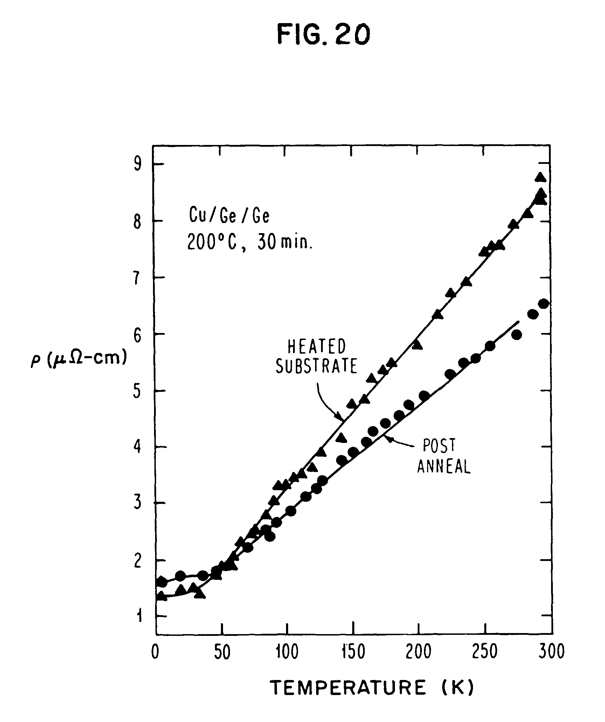

It has been found that copper germanide (Cu₃Ge) offers the lowest room temperature resistivity in a stable compound so as to be particularly suitable for use in contact and gate material. Figure 20 shows the results of resistivity vs. temperature measurements made on copper germanide (Cu₃Ge), Cu₃Ge is formed by reacting Cu with Ge at room temperature or typically temperatures as low as 200°C and below. It may be formed both on Ge or Si substrates. For Cu₃Ge formed on Ge substrates the room temperature (300 K) resistivity is found to be in the range of 5.5- 7µΩ-cm for a 200 nm (2000Å) film. At 4.2 K the resistivity is 1.7µΩ-cm. For films formed on Si substrates the resistivity values at 300 K and 4.2 K are, respectively, 14 and 5µΩ-cm. It is believed that the approximate factor of two increase in resistivity on the Si substrate is primarily due to the incorporation of Si into the Cu₃Ge during annealing. This increase can be reduced by adjusting the relative thicknesses of the Cu and Ge. By comparison, the resistivity values of polycrystalline TiSi₂ and CoSi₂, at room temperature, are 15 and 25 µΩ-cm respectively. Here again it is important to note that while TiSi₂ and CoSi₂ are normally formed at temperatures as high as 600 to 700°C, the low resistivity Cu₃Ge is readily formed at 200°C.

The Ge is first deposited followed by the deposition of the Cu. Their thicknesses are adjusted for the minimal Si incorporation during the formation of the germanide; or, the Cu₃Ge can be used as a gate metal directly on SiO₂ or polysilicon. In the latter instance, the Cu₃Ge has been shown to be thermally stable on SiO₂ up to 600-700°C.

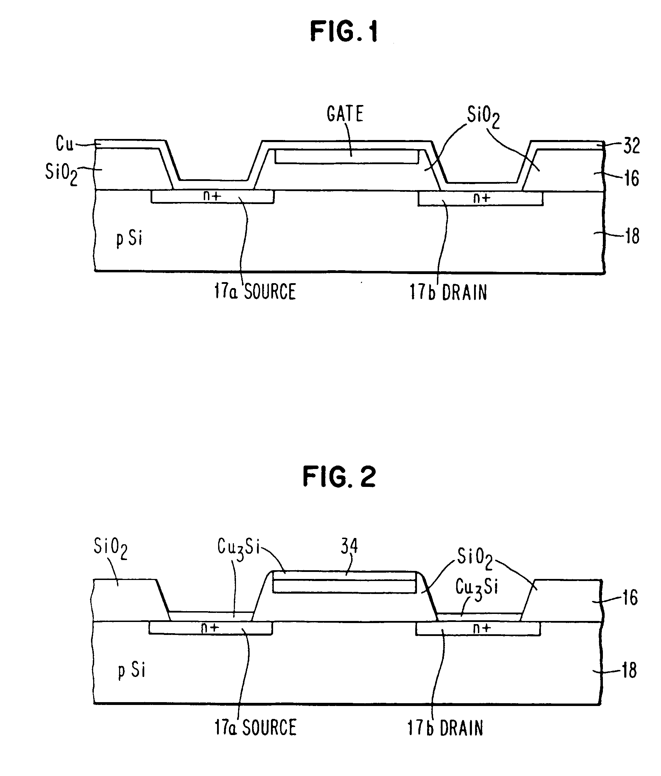

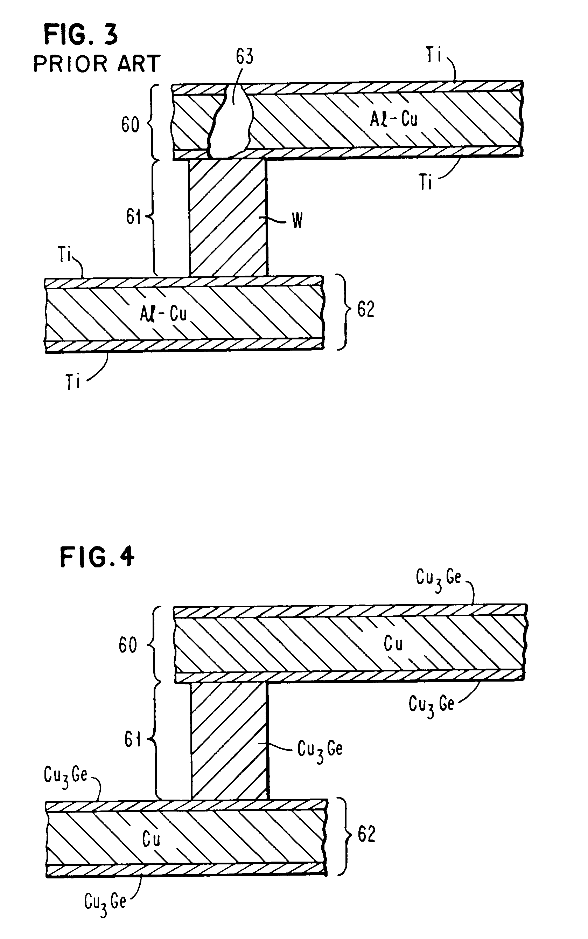

A further application of Cu₃Ge is as electromigration resistant, low resistivity wiring and vias in multilevel interconnect and via structures. More particularly, Fig. 3 illustrates a two level interconnecting structure comprising a Ti/AlCu/Ti upper level 60, a W stud in via 61, and a Ti/AlCu/Ti lower level 62 of a form considered likely to be widely used in the future for multilevel interconnect metallization. However, void-open failures have been observed in the upper Ti/CuAl/Ti lines just above the W stud, as shown at 63 in Fig. 3, which are caused by electromigration. Fig. 4 shows an improved two-level interconnecting structure with significantly improved resistance to electromigration in accordance with the invention. In this structure, the via 61 is filled with Cu₃Ge and the upper and lower levels 60 and 62 are Cu₃Ge/Cu/Cu₃Ge trilayers, as seen in Fig. 4. Both the Cu and Ge may be deposited using chemical vapor deposition (CVD). The thicknesses of Cu and Ge may be adjusted so that Cu₃Ge is formed following a low temperature anneal at 200°C for 30 min. As noted above, it has been found that Cu₃Ge exhibits the lowest room temperature resistivity in a compound, and in addition, Cu₃Ge adheres very well to polyimide, SiO₂ and Si₃N₄. In filling the vias, CVD Ge may first be deposited, followed by deposition of CVD Cu, or, alternatively, alternate CVD layers of Ge and Cu are deposited. Then, a 30 min. anneal at 200°C is performed to produce Cu₃Ge. This arrangement provides the advantage over the prior art of a very low resistance and contact resistance structure with high resistance to electromigration. In addition, it is very simple to fabricate and avoids possible harmful effects to the Si devices.

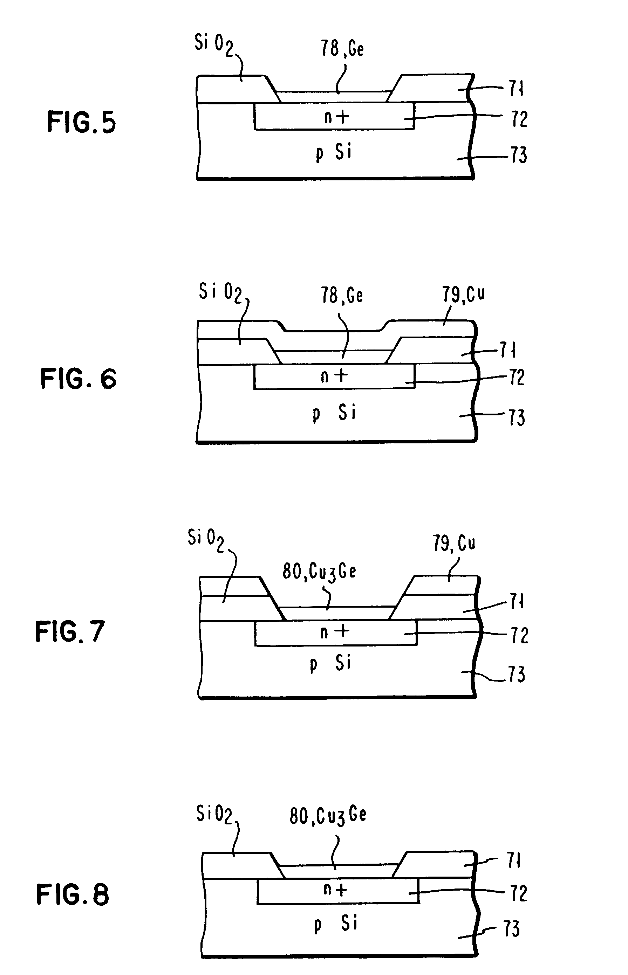

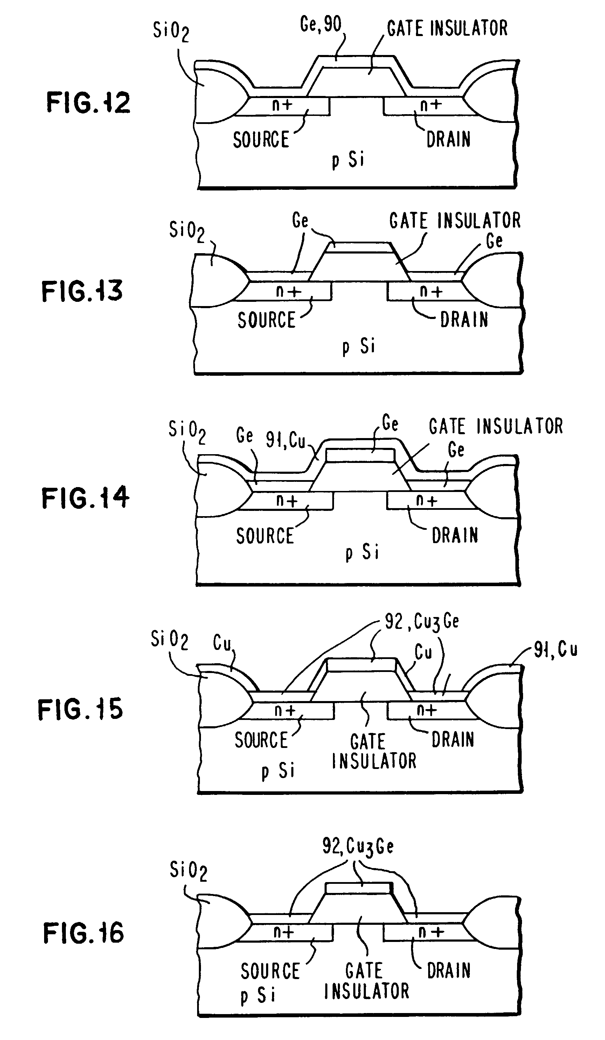

The present invention contemplates a self-aligned Cu₃Ge process to produce low resistance self-aligned Cu₃Ge for advanced bipolar, CMOS, and BiCMOS devices. More particularly, with reference to Figs. 5-8, self-aligned copper germanide can be formed in the following sequence:
1. A selective deposition of a thin Ge film 78 (e.g., 70nm) on exposed silicon (Fig. 5). Such deposition is possible with UHV/CVD or other selective epitaxy processes at fairly low temperatures (≤ 700°C).
2. sputter or evaporate a layer 79 of Cu (e.g. 140nm) on said Ge layer held at room temperature as shown in Fig. 6.
3. the structure shown in Fig. 11 is then heated to temperatures in the range of about 150 - 200°C to form Cu₃Ge 80 as shown in Figure 7.
4. a selective wet chemical etch, using for example 10:1 solution of HNO₃:H₂O with selectivity of 15:1, is then used to remove the unreacted Cu of layer 79 while leaving Cu₃Ge intact, as shown in Fig. 8.

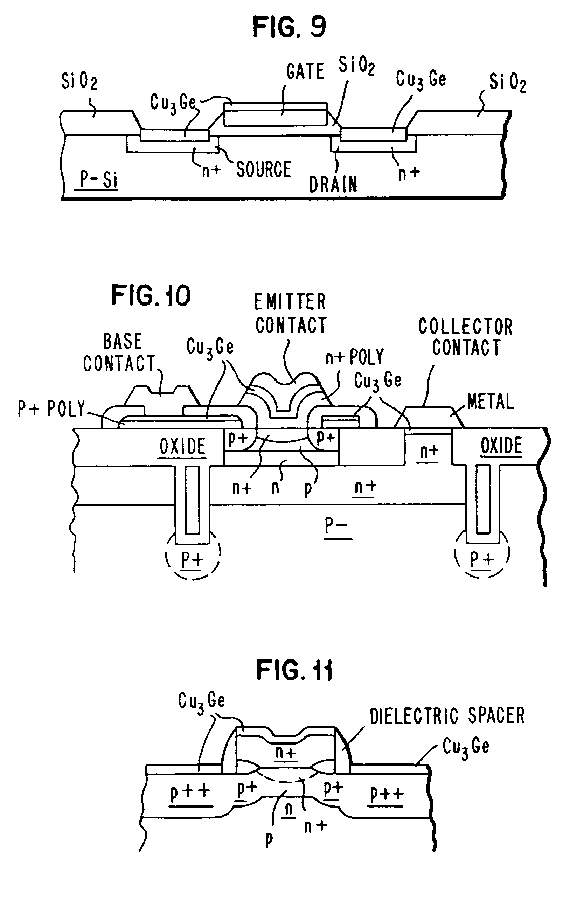

Possible CMOS devices with self-aligned copper germanide over gate, source, and drain may thus be constructed in the form illustrated in Fig. 9. Similarly, examples of bipolar devices with self-aligned Cu₃Ge over emitter, base and collector are shown in Figs. 10 and 11.

An improved technique for fabricating structures at very low temperatures for applications in CMOS devices in accordance with the invention is illustrated in Figs. 12 through 16. As seen in Fig. 12, a layer 90 of Ge may be deposited on a Si substrate of the form shown in Figs. 1, 2, and 9. More particularly, after forming the gate insulator pattern, a thin Ge film 90 (e.g., 70nm) may be selectively deposited in areas above the source and drain on the substrate and the gate oxide or insulator as shown in Fig. 13.

Such deposition is possible with UHV/CVD or other selective epitaxy processes at fairly low temperatures (≤700°C). A layer 91 of Cu is then deposited by a suitable technique, such as evaporating or sputtering, to a thickness of 140nm, for example, on the structure of Fig. 13 held at room temperature creating the structure of Fig. 14. The structure shown in Fig. 14 is then heated to temperatures in the range of 150 - 200°C causing the Ge in the areas above the gate insulator, source, and drain to react with the Cu layer 91 to form Cu₃Ge 92 as shown in Fig. 15. A selective wet chemical etch, using for example 10:1 solution of HNO₃:H₂O with selectivity of 15:1, is then used to remove the unreacted Cu of layer 91 while leaving Cu₃Ge intact, as shown in Fig. 16.

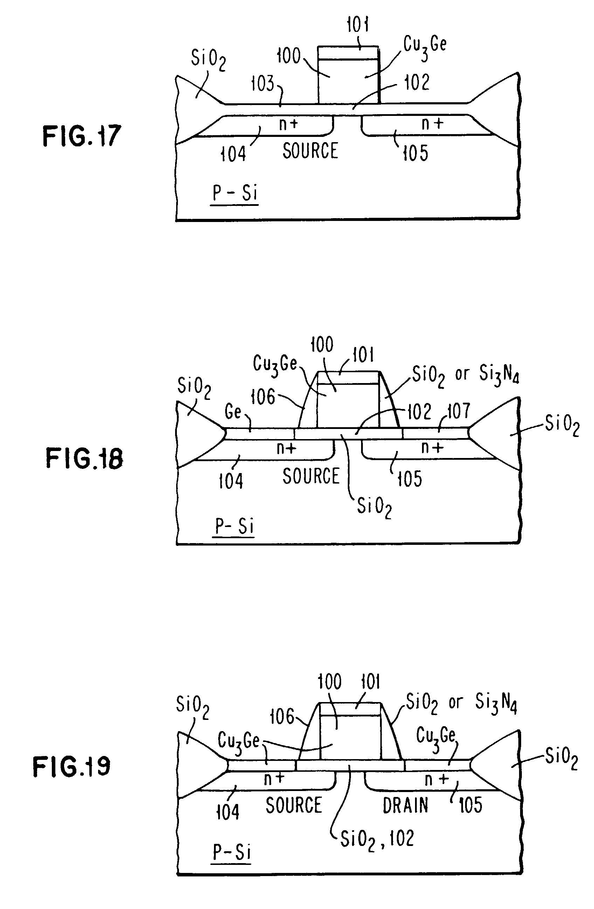

An alternative technique is illustrated in Figs. 17 through 20. An approximately 200 nm layer 100 of Cu₃Ge with an optional insulator cap 101 can be patterned over the gate insulator 102 of thin SiO₂ layer 103 as seen in Fig. 17. The n+ source and drain regions 104, 105, can be formed by ion implantation and drive in a conventional self-aligned fashion. An insulator spacer 106 of SiO₂ or Si₃N₄ is then formed on the sidewall of the Cu₃Ge gate electrode stack 100, 101 as in Fig. 18. The thin SiO₂ layer 103 is then etched away over n+ source and drain regions 104, 105,and Ge 107 is selectively deposited over the exposed source and drain layers. The subsequent processing steps for self-aligned Cu₃Ge formation over the n+ source and drain regions are similar to those described with respect to Figs. 14 through 16. The ultimate structure is of the form shown in Fig. 19.

It will accordingly be seen that systems and processes have been disclosed that provide simple and electrically stable interconnection metallization utilizing copper, which can be achieved with comparatively low-temperature annealing.

It is also contemplated that the Cu-semiconductor phenomenon of the invention is not limited to use in VLSI interconnection metallization. For instance, Ge may be used to retard corrosion in Cu piping through the formation of a surface layer of Cu₃Ge by, e.g., CVD deposition of Ge on the pipe.

## Claims

1. A VLSI method for producing low resistance, self-aligned Cu₃Ge, for advanced bipolar, CMOS, and BiCMOS devices comprising the steps of:
providing a single crystalline semiconductor substrate (73) having at least one doped region (72) formed therein;
depositing a layer (71) of SiO₂ on said substrate with at least one opening to the substrate surface at said doped region;
selectively depositing a layer of Ge (78) on said exposed region on the substrate surface;
depositing a Cu layer (79) on said Ge layer, whereby the Ge layer is held at room temperature;
heating said layers to a temperature in the range of about 150 - 200°C to form a layer (80) of Cu₃Ge; and
removing the unreacted Cu of said Cu layer remaining after heating with a selective etch, preferably by selectively wet etching in a 10:1 solution of HNO₃:H₂O with selectivity of 15:1.

2. A method as in claim 1 wherein said Cu₃Ge layer is additionally formed as a gate metal (92) directly on SiO₂.

3. A method as in claim 2 wherein said Cu₃Ge layer is formed as a gate metal directly on polysilicon.

## Patentansprüche

1. VLSI-Verfahren zum Erzeugen von niederohmigem, selbstjustiertem Cu₃Ge für hochentwickelte bipolare, CMOS- und BiCMOS-Bauelemente, das die Schritte umfaßt:
Bereitstellen eines einkristallinen Halbleitersubstrats (73), das wenigstens ein in demselben ausgebildetes dotiertes Gebiet (72) aufweist;
Aufbringen einer Schicht (71) aus SiO₂ auf dem Substrat mit wenigstens einer Öffnung zu der Substratoberfläche bei dem dotierten Gebiet;
selektives Aufbringen einer Schicht aus Ge (78) auf dem freiliegenden Gebiet auf der Substratoberfläche;
Aufbringen einer Cu-Schicht (79) auf der Ge-Schicht, wobei die Ge-Schicht auf Raumtemperatur gehalten wird;
Erwärmen der Schichten auf eine Temperatur im Bereich von etwa 150° C bis 200° C, um eine Schicht (80) aus Cu3Ge zu bilden; und
Entfernen des nicht reagierten Cu auf der Cu-Schicht, das nach dem Erwärmen verbleibt, mit einem selektiven Ätzvorgang, vorzugsweise durch selektives Naßätzen in einer 10:1-Lösung aus HNO₃:H₂O mit einer Selektivität von 15:1.

2. Verfahren nach Anspruch 1, wobei die Cu₃Ge-Schicht zusätzlich als ein Gate-Metall (92) direkt auf dem SiO₂ gebildet wird.

3. Verfahren nach Anspruch 2, wobei die Cu₃Ge-Schicht als ein Gate-Metall direkt auf Polysilicium gebildet wird.

## Revendications

1. Un procédé VLSI de production de Cu₃Ge à faible résistance, auto-aligné pour des dispositifs évolués bipolaires CMOS et BiCMOS comprenant les étapes consistant à :
fournir un substrat semi-conducteur (73) monocristallin ayant au moins en son sein une zone dopée (72);
déposer une couche (71) de SiO₂ sur ledit substrat avec au moins une ouverture sur la surface du substrat, dans ladite zone dopée;
déposer sélectivement une couche de Ge (78) sur ladite zone exposée sur la surface de substrat;
déposer une couche de Cu (79) sur ladite couche de Ge, de manière que la couche de Ge soit maintenue à température ambiante;
chauffer lesdites couches à une température située dans la plage allant d'environ 150 à 200 °C pour former une couche (80) de Cu₃Ge; et
enlever le Cu n'ayant pas réagi, de ladite couche en Cu subsistant après chauffage, par une morsure sélective, de préférence par une morsure humide sélective, dans une solution de HNO₃:H₂O de proportion 10:1, avec une sélectivité de 15:1.

2. Un procédé selon la revendication 1, dans lequel ladite couche en Cu₃Ge est en plus formée en un métal de grille (92) directement sur le SiO₂.

3. Un procédé selon la revendication 2, dans lequel ladite couche en Cu₃Ge est formée en métal de grille directement sur du polysilicium.
